# EUROPEAN PATENT SPECIFICATION

(11) **EP 0 469 584 B1**
(45) Date of publication and mention of the grant of the patent: **05.03.1997**
(21) Application number: 91112888.2
(22) Date of filing: 31.07.1991
(51) Int. Cl.: G03F 7/039

(54) **Resist composition**
Photolackzusammensetzung
Composition de photorésist

(30) Priority: 31.07.1990 JP 205678/90
(43) Date of publication of application: 05.02.1992
(73) Proprietor: NIPPON PAINT CO., LTD., Osaka-shi Osaka 530 (JP)
(72) Inventor: Matsumura, Akira, Hirakata-shi, Osaka-fu (JP); Ishikawa, Katsukiyo, Kuze-gun, Kyoto-fu (JP)
(74) Representative: Hansen, Bernd, Dr. Dipl.-Chem.

(56) References cited:
- EP-A- 0 102 450
- EP-A- 0 366 590
- EP-A-03 631 989
- MICROELECTRONIC ENGINEERING, vol. 1, no. 4, December 1983, pages 269-293, Amsterdam, NL; S. MCDONALD et al.: "Advances in the design of organic resist materials"

## Description

### FIELD OF THE INVENTION

The present invention relates to a resist composition which can be used as either positive type or negative type. More particularly, it relates to a resist composition which is suitable for printing plates or photoresists.

### BACKGROUND OF THE INVENTION

Resist compositions are classified into two groups, one is a negative type which cures a portion on which light is irradiated, and the other is a positive type which elutes a portion on which light is irradiated.

Japanese Kokai Publication 59-45439 (corresponding to USP 4,491,628 discloses a resin composition which comprises a polymer (e.g. polystyrene) repeatedly having groups, such as t-butyl esters or t-butyl carbonates, and a photopolymerization initiator. Upon irradiating ultraviolet onto the resin composition, the photopolymerization initiator generates acids which change the t-butyl esters or t-butyl carbonates to corresponding base-soluble phenols or base-soluble carboxylic acids, which are developable with a basic solution. Thus, this composition is a positive type photoresist. Also, in the composition, the portion which is not exposed to light is soluble with a mixture of n-hexane and methylene chloride, but the other portion which is exposed to light is not soluble with the mixture, thus being capable of using a negative type photoresist.

Similar resin compositions are also known from EP-A-0 363 198 and EP-A-0 366 590.

However, in case where the composition is used as negative type, the light exposed portion, which remains without developing, is not crosslinked and inferior to chemical resistance and the other physical properties.

### SUMMARY OF THE INVENTION

The present invention is to provide a photoresist composition which can be used as either positive type or negative type, provided that, in either positive or negative, the remaining portion has excellent physical properties, such as chemical resistance and the like. The resist composition of the present invention comprises;
(a) 20 to 90% by weight of a polymer having a pendant branched group selected from the group consisting of a t-butyl ester of a carboxylic acid, a trityl ester of a carboxylic acid, a benzhydryl ester of a carboxylic acid, a benzyl ester of a pendant carboxylic acid, a t-butyl carbonate of a phenol, a trityl carbonate of a phenol, a benzhydryl carbonate of a pendant phenol, and a benzyl carbonate of a pendant phenol, which is unstable against acid and present repeatedly,
(b) 10 to 80% by weight of a polymer having a group selected from the group consisting of 2-hydroxyethyl, 3-hydroxypropyl, isocyanate and glycidyl group which is reactive at an elevated temperature with groups which are produced by decomposition of the branched groups of the polymer (a) with acid, and
(c) 0.1 to 50% by weight, based on the total amount of the components (a) and (b), of a photopolymerisation initiator which is an onium salt having a metal complex halogenate as counter ion and which generates an acid in response to a light irradiation.

Also, the present invention provides a resist composition which comprises;
(d) a polymer pendanted with both a branched group which is unstable against acid (cf. above) and present repeatedly and a group which is reactive at an elevated temperature with the groups (cf. above) which are produced by the decomposition of the branched groups with acid, and
(c) 0.1 to 50 % by weight, based on the amount of the component (d), of the above photopolymerization initiator which generates an acid in response to a light irradiation.

### DETAILED DESCRIPTION OF THE INVENTION

The branched group which is unstable against acid and present repeatedly is preferably a t-butyl ester of a carboxylic acid or a t-butyl carbonate of a phenol, but it can also be a trityl, benzhydryl or benzyl ester of a carboxylic acid or a trityl, benzhydryl or benzyl carbonate of a phenol.

The polymer pendanted with the branched group mentioned above may be a homopolymer or a copolymer of polymerizable compounds having the branched group which is unstable against acid. Examples of the polymerizable compounds having the branched group which is unstable against acid are p-t-butyxycarbonyloxy-alpha-methylstyrene, p-t-butoxycarbonyloxystyrene, t-butyl-p-vinyl benzoate, t-butyl-p-isopropenylphenyloxyl acetate, t-butyl methacrylate and the like.

A monomer, which is copolymerized with the above polymerizable compounds having the branched group which is unstable against acid, includes olefins or diolefins, such as styrene, alpha-methylstyrene, alpha-ethylstyrene, ethylene, propylene, butylene, amylene, hexylene, butadiene-1,3, isoprene and the like; halogenized monoolefins or diolefins, such as alpha-chlorostyrene, alpha-bromostyrene, 2,5-dichlorostyrene, 2,5-dibromostyrene, 3,4-dichlorostyrene and the like; unsaturated acid esters, such as vinyl acetate, vinyl propionate, vinyl butylate, vinyl isobutylate, vinyl valerate, vinyl caproate, vinyl enanthate, vinyl benzoate, vinyl toluate, vinyl-p-chlorobenzoate, methyl (meth)acrylate, ethyl (meth)acrylate, propyl (meth)acrylate, isopropyl (meth)acrylate, butyl (meth)acrylate, isobutyl (meth)acrylate, amyl (meth)acrylate, hexyl (meth)acrylate, 2-ethylhexyl (meth)acrylate, heptyl (meth)acrylate, octyl (meth)acrylate, 3,5,5-trimethylhexyl (meth)acrylate, decyl (meth)acrylate, dodecyl (meth)acrylate, dimethyl maleate, diethyl maleate, diallyl maleate, dimethyl fumarate, diethyl fumarate, dimethallyl fumarate and diethyl glutarate; allyl halides or cyanides, such as allyl chloride, allyl cyanide, allyl bromide, allyl fluoride, allyl iodide and allyl chloridecarbonate; unsaturated nitriles, such as acrylonitrile, methacrylonitrile, ethacrylonitrile, 3-octenenitrile, crotonitrile and oleonitrile; and the like.

The polymer (b) of the present invention has a group which is reacted at an elevated temperature with the groups (e.g. a carboxyl group or a phenol acid group) which are produced by the decomposition of the branched groups of the polymer (a) with acid. The polymer (b) may be prepared by polymerizing a monomer having the reactive group and optionally a copolymerizable monomer. The monomers having the reactive group are 2-hydroxyethyl (meth)acrylate, 3-hydroxypropyl (meth)acrylate, glycidyl (meth)acrylate, allyl glycidyl ether, vinyl isocyanate, (meth)acryloyl isocyanate and the like. The copolymerizable monomer can be the monomer listed for the copolymer.

The polymers (a) and (b) can be one polymer component, thus a polymer (a,b) pendanted with the above branched groups which are unstable against acid and present repeatedly, and having the above groups which are reactive at an elevated temperature with the groups which are produced by the decomposition of the branched groups of the polymer (a) with acid. The polymer (a,b) can be prepared by polymerizing the monomer mentioned for the polymers (a) and (b).

The polymerization reaction is known to the art, generally conducted at a temperature of 50 to 200 °C in the presence or absence of a solvent.

The photopolymerization initiator (c) which generates an acid in response to a light irradiation is an onium salt which is known to the art. Typical examples of the initiators are diaryliodonium salts, triarylsulfonium salts and triarylselenium salts. The counter anions are metal complex halogenates, such as tetrafluoroborates, trifluoromethanesulfonate, hexafluoroantimonate, hexafluoroarsenate and hexafluorophosphate. These photopolymerization initiators (c) generate strong acids in response to a light irradiation, which attacks the branched groups which are unstable against acid to decompose to release carboxyl groups or phenolic acid groups. The initiator is present in the composition in an amount of 0.1 to 50 % by weight, preferably 1 to 30 % by weight, based on the total weight of the components (a) and (b).

The resist composition may contain a photosensitizer in order to be sensitive with a light having wave lengths within ultraviolet to visible light. The photosensitizer includes polycyclic aromatic compounds, such as pyrene and perylene; other dyes, such as acrydine; and the like. An amount of the photosensitizer may be within the range of. 0.01 to 10 % by weight, preferably 0.1 to 5 % by weight, based on the total amount of the component (a) and (b).

The resist composition of the present invention may be prepared by mixing the above components. Mixing is conducted in the presence of a solvent or intact in a cool and dark place. Examples of the solvents are ketones, such as acetone, methyl ethyl ketone and cyclohexanone; esters, such as ethyl acetate, butyl acetate and ethyleneglycol acetate; ethers, such as tetrahydrofuran and dioxane; and the like.

The obtained composition is coated on a substrate and dried to form a resist layer. The layer is exposed to light through a positive film or a negative film, and then developed. In case where the composition is used as negative type, it is necessary to heat the composition before developing. The heating promotes the reaction between the acid produced upon exposure and the group which is reactive with the acids. It is preferred that the temperature is within in the range of 100 to 250 °C, preferably 150 to 200 °C. The development can be conducted with an alkaline solution for positive type or a solvent which dissolves the polymer components of the composition for negative type. Examples of the alkaline compounds for the developers are sodium hydroxide, potassium hydroxide, sodium carbonate, potassium carbonate, sodium metasilicate, potassium metasilicate and the like. The alkaline developer solution may contain the alkaline compound in an amount of 0.1 to 10 % by weight.

According to the present invention, the resist composition has good image developing ability and the developed images have excellent physical properties (e.g. chemical resistance) with either a positive or negative treatment.

### EXAMPLES

The present invention is illustrated by the following Examples which, however, are not construed as limiting the present invention to their details.

### Synthesis Example 1

Fifty gram of tert-butyl methacrylate was added into 50 g of a xylene solution containing 0.5 g of azobisisobutylonitrile and mixed for 10 hours at 60 °C in nitrogen gas flow. After cooling the mixture, the content was diluted with tetrahydrofuran, to which petroleum ether was added to separate the resin. The separated white resin was rinsed with petroleum ether and methanol. The resin weighed 41.7 g (yield 83.4 %) and had a number average molecular weight (GPC) of 50,000.

### Synthesis Example 2

Fifty gram of p-t-butoxycarbonyloxystyrene was added into 50 g of a xylene solution containing 0.3 g of azobisisobutylonitrile and mixed for 10 hours at 75 °C in nitrogen gas flow. After cooling the mixture, the content was diluted with dichloromethane, to which petroleum ether was added to separate the resin. The separated white resin was rinsed with petroleum ether and methanol. The resin weighed 39.8 g (yield 79.6 %) and had a number average molecular weight (GPC) of 41,000.

### Synthesis Example 3

Fifty gram of 2-hydroxyethyl methacrylate was added into 50 g of a xylene solution containing 0.5 g of azobisisobutylonitrile and mixed for 7 hours at 70 °C in nitrogen gas flow. After cooling the mixture, the content was treated as generally described in Synthesis Example 1. The obtained resin weighed 44.5 g (yield 89.0 %) and had a number average molecular weight (GPC) of 48,000.

### Synthesis Example 4

Twenty five gram of tert-butyl methacrylate and 25 g of 2-hydroxyethyl methacrylate were added into 50 g of a xylene solution containing 0.5 g of azobisisobutylonitrile and mixed for 8 hours at 70 °C in nitrogen gas flow. After cooling the mixture, the content was treated as generally described in Synthesis Example 1. The obtained resin weighed 43.6 g (yield 87.2 %) and had a number average molecular weight (GPC) of 50,000.

### Example 1

A solution having a solid content of 20 % by weight was prepared by mixing 10 g of the polymer of Synthesis Example 1 and 10 g of the polymer of Synthesis Example 3 in tetrahydrofuran, to which triphenylsulfonium hexafluoroantimonate was added in an amount of 20 % by weight based on the polymers amount. The obtained solution was rotary-coated at 2,000 rpm on a metal substrate to form a resist film with 2.0 micron. It was dried at 100 °C for 10 minutes. A positive film was contacted with the resist film and exposed to ultraviole at 100 mJ/cm². Then, it was heated at 100 °C for 5 minutes and developed with a 1 % sodium metasilicate solution at 45 °C for 60 seconds, thus obtaining a positive images having good developing ability. The developed plate was further exposed to ultraviolet at 100 mJ/cm² and then heated at 150 °C for 30 minutes to obtain a cured positive images having good chemical resistance.

Similarly, a negative film was contacted with the resist film and exposed to ultraviolet at 100 mJ/cm² and heated at 170 °C for 30 minutes. It was then developed with tetrahydrofuran at 35 °C for 60 seconds to obtain a negative images having good chemical resistance.

### Example 2

A solution having a solid content of 20 % by weight was prepared by mixing 16 g of the polymer of Synthesis Example 2 and 4 g of the polymer of Synthesis Example 3 in tetrahydrofuran, to which 20 % by weight of diphenyliodonium hexafluoroarsenate and 3 % by weight of pyrene were added, based on the polymers amount. The same treatment as Example 1 was conducted to form a resist film with 2.3 micron. It was dried at 100 °C for 10 minutes. A positive film was contacted with the resist film and exposed to ultraviole at 150 mJ/cm². Then, it was heated at 100 °C for 5 minutes and developed with a 1 % sodium metasilicate solution at 35 °C for 60 seconds, thus obtaining a positive images having good developing ability.

Similarly, a negative film was contacted with the resist film and exposed to ultraviolet at 200 mJ/cm² and heated at 180 °C for 30 minutes. It was then developed with cyclohexane at 35 °C for 60 seconds to obtain a negative images having good chemical resistance.

### Example 3

A solution having a solid content of 20 % by weight was prepared by mixing 20 g of the polymer of Synthesis Example 4 in tetrahydrofuran, to which triphenylsulfonium hexafluoroantimonate was added in an amount of 15 % by weight based on the polymers amount. The obtained solution was rotary-coated at 2,000 rpm on a metal substrate to form a resist film with 2.3 micron. It was dried at 100 °C for 10 minutes. The plate was treated as generally described in Example 1 and identified that it was employed as either positive and negative type resists.

## Claims

1. A resist composition comprising:
(a) 20 to 90% by weight of a polymer having a pendant branched group selected from the group consisting of a t-butyl ester of a carboxylic acid, a trityl ester of a carboxylic acid, a benzhydryl ester of a carboxylic acid, a benzyl ester of a pendant carboxylic acid, a t-butyl carbonate of a phenol, a trityl carbonate of a phenol, a benzhydryl carbonate of a pendant phenol, and a benzyl carbonate of a pendant phenol, which is unstable against acid and present repeatedly,
(b) 10 to 80% by weight of a polymer having a group selected from the group consisting of 2-hydroxyethyl, 3-hydroxypropyl, isocyanate and glycidyl group which is reactive at an elevated temperature with groups which are produced by decomposition of the branched groups of the polymer (a) with acid, and
(c) 0.1 to 50% by weight, based on the total amount of the components (a) and (b), of a photopolymerisation initiator being an onium salt having a metal complex halogenate as counter anion, which generates an acid in response to irradiation with light.

2. A resist composition comprising
(d) 20 to 90% by weight of a polymer having both a pendant branched group selected from the group consisting of a t-butyl ester of a pendant carboxylic acid, a trityl ester of a pendant carboxylic acid, a benzhydryl ester of a pendant carboxylic acid, a benzyl ester of a pendant carboxylic acid, a t-butyl carbonate of a pendant phenol, a trityl carbonate of a pendant phenol, a benzhydryl carbonate of a pendant phenol, and a benzyl carbonate of a pendant phenol, which is unstable against acid and present repeatedly and a pendant group selected from the group consisting of 2-hydroxyethyl, 3-hydroxypropyl, isocyanate and glycidyl group which is reactive at an elevated temperature with groups which are produced by decomposition of the branched groups of the polymer (a) with acid, and
(c) 0.1 to 50% by weight, based on the total amount of the components (a) and (b), of a photopolymerisation initiator being an onium salt having a metal complex halogenate as counter anion, which generates an acid in response to irradiation with light.

3. A resist composition according to claim 1 or claim 2, wherein said branched group, which is unstable acid is a t-butyl ester group of a carboxylic acid or a t-butyl carbonate of a phenol.

4. A resist composition according to claim 1 or claim 2 wherein said group, which is reactive at an elevated temperature with the groups which are produced by the decomposition of the branched groups of the polymer (a) with acid is a 2-hydroxyethyl or a 3-hydroxypropyl group.

5. A resist composition according to claim 1 or claim 2 further comprising a photosensitiser in an amount of 0.01 to 10% by weight based on the total amount of the components (a) and (b).

## Patentansprüche

1. Resistzusammensetzung, umfassend:
(a) 20 bis 90 Gew.-% eines Polymers mit einer anhängenden verzweigten Gruppe, ausgewählt aus der Gruppe, bestehend aus einem tert-Butylester, einer Carbonsäure, einem Tritylester einer Carbonsäure, einem Benzhydrylester einer Carbonsäure, einem Benzylester einer anhängenden Carbonsäure, einem tert-Butylcarbonat eines Phenols, einem Tritylcarbonat eines Phenols, einem Benzhydrylcarbonat eines anhängenden Phenols und einem Benzylcarbonat eines anhängenden Phenols, welches gegenüber Säure instabil ist und wiederholt vorhanden ist,
(b) 10 bis 80 Gew.-% eines Polymers mit einer Gruppe, ausgewählt aus der Gruppe, bestehend aus einer 2-Hydroxyethyl-, 3-Hydroxypropyl-, Isocyanat- und Glycidylgruppe, die bei einer erhöhten Temperatur mit Gruppen, die durch Zersetzung der verzweigten Gruppen des Polymers (a) mit Säure gebildet werden, reaktiv ist, und
(c) 0,1 bis 50 Gew.-%, bezogen auf die Gesamtmenge der Komponenten (a) und (b) eines Fotopolymerisations-Initiators, der ein Oniumsalz ist, welches ein Metallkomplexhalogenat als Gegenanion hat, und welches in Ansprechung auf die Bestrahlung mit Licht eine Säure erzeugt.

2. Resistzusammensetzung, umfassend:
(d) 20 bis 90 Gew.-% eines Polymers, das sowohl eine anhängende verzweigte Gruppe hat, ausgewählt aus der Gruppe, bestehend aus einem tert-Butylester einer anhängenden Carbonsäure, einem Tritylester einer anhängenden Carbonsäure, einem Benzydrylester einer anhängenden Carbonsäure, einem Benzylester einer anhängenden Carbonsäure, einem tert-Butylcarbonat eines anhängenden Phenols, einem Tritylcarbonat eines anhängenden Phenols, einem Benzhydrylcarbonat eines anhängenden Phenols, einem Benzylcarbonat eines anhängenden Phenols, welches gegen Säure instabil ist und wiederholt vorkommt, als auch eine anhängende Gruppe hat, ausgewählt aus der Gruppe, bestehend aus einer 2-Hydroxyethyl-, 3-Hydroxypropyl-, Isocyanat- und einer Glycidylgruppe, die bei einer erhöhten Temperatur mit Gruppen, die durch Zersetzung der verzweigten Gruppen des Polymers (a) mit Säure gebildet werden, reaktiv ist, und
(c) 0,1 bis 50 Gew.-%, bezogen auf die Gesamtmenge der Komponenten (a) und (b) eines Fotopolymerisations-Initiators, der ein Oniumsalz ist mit einem Metallkomplexhalogenat als Gegenanion, welcher eine Säure in Ansprechung auf die Bestrahlung mit Licht erzeugt.

3. Resistzusammensetzung gemäß Anspruch 1 oder Anspruch 2, in welcher die verzweigte Gruppe, die gegenüber Säure instabil ist, eine tert-Butylestergruppe einer Carbonsäure oder ein tert-Butylcarbonat eines Phenols ist.

4. Restistzusammensetzung gemäß Anspruch 1 oder Anspruch 2, worin die Gruppe, die bei erhöhter Temperatur mit den Gruppen, die durch Zersetzung der verzweigten Gruppen des Polymers (a) mit Säure reaktiv ist, eine 2-Hydroxyethyl- oder eine 3-Hydroxypropylgruppe ist.

5. Resistzusammensetzung gemäß Anspruch 1 oder Anspruch 2, welche weiterhin einen Fotosensibilisator in einer Menge von 0,01 bis 10 Gew.-%, bezogen auf die Gesamtmenge der Komponenten (a) und (b) umfaßt.

## Revendications

1. Composition de vernis de masquage, comprenant:
(a) 20 à 90% en poids d'un polymère présentant un groupe ramifié latéral choisi dans l'ensemble constitué d'un t-butylester d'un acide carboxylique, d'un tritylester d'un acide carboxylique, d'un benzhydrylester d'un acide carboxylique, d'un benzylester d'un acide carboxylique latéral, d'un t-butylcarbonate d'un phénol, d'un tritylcarbonate d'un phénol, d'un benzhydrylcarbonate d'un phénol latéral et d'un benzylcarbonate d'un phénol latéral, qui est instable vis-à-vis des acides et présent de manière répétée,
(b) 10 à 80% en poids d'un polymère présentant un groupe choisi dans l'ensemble constitué de groupes 2-hydroxyéthyle, 3-hydroxypropyle, isocyanate et glycidyle, qui, à température élevée, est réactif avec des groupes qui sont produits par décomposition par un acide des groupes ramifiés du polymère (a), et
(c) 0,1 à 50% en poids, calculés sur la quantité totale des composants (a) et (b), d'un initiateur de photopolymérisation qui est un sel onium présentant un halogénate complexe de métal comme contre-anion, qui produit un acide en réponse à une irradiation par la lumière.

2. Composition de vernis de masquage, comprenant:
(d) 20 à 90% en poids d'un polymère présentant à la fois un groupe ramifié latéral choisi dans l'ensemble constitué d'un t-butylester d'un acide carboxylique latéral, d'un tritylester d'un acide carboxylique latéral, d'un benzhydrylester d'un acide carboxylique latéral, d'un benzylester d'un acide carboxylique latéral, d'un t-butylcarbonate d'un phénol latéral, d'un tritylcarbonate d'un phénol latéral, d'un benzhydrylcarbonate d'un phénol latéral et d'un benzylcarbonate d'un phénol latéral, qui est instable vis-à-vis des acides et est présent de manière répétée, et un groupe latéral choisi dans l'ensemble constitué des groupes 2-hydroxyéthyle, 3-hydroxypropyle, isocyanate et glycidyle, qui, à température élevée, est réactif avec des groupes qui sont produits par décomposition par un acide des groupes ramifiés du polymère (a), et
(c) 0,1 à 50% en poids, calculés sur la quantité totale des composants (a) et (b), d'un initiateur de photopolymérisation qui est un sel onium qui présente un halogénate complexe de métal comme contre-anion, qui produit un acide en réponse à une irradiation par la lumière.

3. Composition de vernis de masquage selon la revendication 1 ou la revendication 2, dans laquelle ledit groupe ramifié qui est instable vis-à-vis des acides est un groupe t-butylester d'un acide carboxylique ou un t-butylcarbonate d'un phénol.

4. Composition de vernis de masquage selon la revendication 1 ou la revendication 2, dans laquelle ledit groupe qui, température élevée, est réactif avec les groupes qui sont produits par la décomposition par un acide des groupes ramifiés du polymère (a) est un groupe 2-hydroxyéthyle ou un groupe 3-hydroxypropyle.

5. Composition de vernis de masquage selon la revendication 1 ou la revendication 2, comprenant en outre un agent de photosensibilisation en une quantité de 0,01 à 10% en poids, calculés sur la quantité totale des composants (a) et (b).
